# FASCICULE DE BREVET EUROPEEN

(11) **EP 2 355 643 B1**
(45) Date de publication et mention de la délivrance du brevet: **28.11.2012**
(21) Numéro de dépôt: 11153868.2
(22) Date de dépôt: 09.02.2011
(51) Int. Cl.: H05K 7/20

(54) **DISPOSITIF AUXILIAIRE D'EVACUATION PAR CONDUCTION DE LA CHALEUR PRODUITE PAR UNE CARTE ELCTRONIQUE**
Hilfsvorrichtung zur Ableitung durch Wärmeleitung, die über eine elektronische Karte gesteuert wird
Auxiliary device for evacuating the heat produced by an electronic card by conduction

(30) Priorité: 09.02.2010 FR 1000525
(43) Date de publication de la demande: 10.08.2011
(73) Titulaire: Kontron Modular Computers S.A., 83078 Toulon Cedex (FR)
(72) Inventeur: Tissot, Serge, 83400, HYERES (FR)
(74) Mandataire: Lucas, Laurent Jacques

(56) Documents cités:
- EP-A1- 2 061 296
- FR-A1- 2 907 634
- FR-A1- 2 925 254
- US-A1- 2006 044 760

## Description

La présente invention concerne un dispositif auxiliaire d'évacuation par conduction de la chaleur produite par une carte électronique. Elle s'applique notamment au refroidissement de calculateurs modulaires comprenant plusieurs cartes électroniques amovibles refroidies par conduction.

Les cartes électroniques sont soumises à des standards ou normes d'interopérabilité qui définissent, selon les trois dimensions, les caractéristiques dimensionnelles des cartes et des glissières dans lesquelles ces cartes sont insérées. Ces contraintes de dimensionnement font obstacle à la réalisation de glissières thermiques allongées, plus épaisses, ou multiples qui optimiseraient les échanges thermiques entre la carte et le châssis.

Divers éléments peuvent permettre de refroidir une carte électronique et ses composants par conduction thermique. Par exemple, il est possible de fixer un drain thermique sur tout ou partie de la carte électronique, de façon à évacuer la chaleur produite par la carte vers l'extérieur comme le châssis dans lequel la carte électronique peut être encastrée

Une carte électronique comprend généralement des points ayant une température plus élevée que le reste de la carte. Ces points chauds correspondent en général aux endroits où se trouvent certains composants, par exemple des processeurs. Pour améliorer l'évacuation de la chaleur de ces points chauds, il est possible d'utiliser des caloducs. Ces derniers sont de longs cylindres, souvent métalliques (par exemple en cuivre ou en aluminium) renfermant un fluide tel que de l'eau. Cette eau se trouve en équilibre entre sa phase gazeuse et sa phase liquide, en absence de tout autre gaz. Dans la portion du caloduc se situant près du composant à refroidir, l'eau chauffe et se vaporise en emmagasinant de l'énergie provenant de la chaleur émise par ce composant. Ce gaz remonte alors le caloduc pour arriver près d'un système de refroidissement où il sera refroidi, jusqu'à ce qu'il se condense pour redevenir à nouveau un liquide, et céder de l'énergie à l'air ambiant sous forme de chaleur.

Une demande de brevet français référencée sous le numéro de publication FR2925254 propose un dispositif de refroidissement d'une carte électronique à l'aide de caloducs. Ce dispositif permet d'évacuer la chaleur produite par des composants électroniques de la carte en transférant cette chaleur vers les points de contact entre la carte et la glissière du châssis dans laquelle elle est insérée.

Toutefois, ce dispositif comporte plusieurs inconvénients. En premier lieu, la surface d'échange thermique disponible entre la carte et le châssis est limitée par la taille normalisée de la glissière. Ensuite, il n'est pas prévu pour une installation optionnelle. Autrement dit, il ne peut pas être installé sur une carte pourvue d'un drain thermique standard, et une fois que le dispositif est installé sur une carte, il n'est pas possible de le retirer sans devoir modifier de nouveau le drain thermique associé à la carte ou le châssis dans laquelle elle est insérée. Enfin, ce dispositif ne garantit pas une indépendance des chemins d'évacuation thermiques jusqu'au point froid.

Un but de l'invention est de proposer des moyens d'évacuation efficaces de la chaleur produite par une carte électronique tout en conservant son caractère amovible et en respectant les contraintes dimensionnelles imposées par les normes. A cet effet, l'invention a pour objet un dispositif auxiliaire pour évacuer par conduction la chaleur produite par un ou plusieurs composants d'une carte électronique montée dans au moins une glissière formée dans un châssis externe à ladite carte, ledit châssis formant un mur froid, le dispositif comprenant un drain thermique recouvrant tout ou une partie de ladite carte, le dispositif comprenant au moins une première pièce de conduction thermique montée pour capter les calories produites par un ou plusieurs composants, un caloduc reliant ladite première pièce avec une deuxième pièce de conduction thermique, caractérisé en ce que le caloduc est disposé dans un plan sensiblement parallèle et extérieur au drain thermique, le caloduc étant pourvu d'une élasticité conférant à la deuxième pièce de conduction thermique une mobilité, le dispositif comprenant des moyens de serrage aptes à presser la deuxième pièce mobile contre une partie dudit mur froid située à l'écart de ladite glissière.

Les moyens de serrage peuvent comprendre au moins deux parties mobiles l'une par rapport à l'autre, une première partie étant fixée à la deuxième pièce de conduction thermique, une deuxième partie étant maintenue immobile par rapport au drain thermique.

Selon un mode de réalisation du dispositif selon l'invention, le dispositif comprend, sur le drain thermique, des moyens de blocage configurés pour maintenir les moyens de serrage et la deuxième pièce de conduction thermique en place lorsqu'un serrage de ladite deuxième pièce de conduction est effectué contre le mur froid.

Selon un mode de réalisation du dispositif selon l'invention, la première pièce de conduction thermique, la deuxième pièce de conduction thermique et le caloduc sont formés d'une seule et même pièce.

Selon un mode de réalisation du dispositif selon l'invention, la première pièce de conduction thermique est un bloc de matériau conducteur accolé à un flanc du drain thermique à proximité d'un point chaud.

Au moins une pièce de conduction thermique peut être un capot obturant une ouverture formée dans le drain thermique, ledit capot étant placé en contact avec un point chaud de la carte électronique.

Selon un mode de réalisation du dispositif selon l'invention, le caloduc est conformé en forme de U dans un plan parallèle au plan formé par le drain thermique, la première extrémité du U étant reliée à la première pièce de conduction, la deuxième extrémité du U étant reliée à la deuxième pièce de conduction.

Selon un mode de réalisation du dispositif selon l'invention, le caloduc forme une boucle fermée en contact avec la première pièce de conduction thermique et la deuxième pièce de conduction thermique.

Selon un autre mode de réalisation du dispositif selon l'invention, le caloduc relie une première pièce de conduction montée près d'un premier point chaud à une deuxième pièce de conduction montée près d'un mur froid, le caloduc reliant la deuxième pièce de conduction à une troisième pièce de conduction montée près d'un deuxième point chaud, la troisième pièce de conduction à une quatrième pièce de conduction montée près d'un mur froid, ladite quatrième pièce étant reliée par le caloduc à la première pièce de conduction.

L'invention a également pour objet une carte électronique refroidie par conduction comprenant un dispositif tel que décrit plus haut.

Le dispositif selon l'invention peut être utilisé en complément de dispositif de refroidissement déjà en place ; il permet d'évacuer davantage de chaleur tout en étant compatible avec les glissières normalisées présentes dans les châssis pour cartes électroniques. Il exploite la relative élasticité du caloduc pour pouvoir, dans un premier temps, insérer la carte électronique pourvue du dispositif selon l'invention, dans un châssis, puis dans un deuxième temps, actionner les moyens de serrage pour former un chemin d'évacuation auxiliaire des calories du point chaud jusqu'au mur froid.

Un avantage du dispositif selon l'invention est que le chemin auxiliaire parallèle d'évacuation des colories permet de mieux refroidir la carte en abaissant la résistance thermique de la carte vers le mur froid, malgré la difficulté à augmenter la surface d'échange thermique entre le drain et le mur froid du fait de la normalisation des dimensions des dispositifs de base.

Le dispositif selon l'invention comporte notamment l'avantage d'être monté optionnellement, c'est-à-dire de pouvoir être monté ou retiré aisément de la carte et du drain thermique. On peut ainsi concevoir plusieurs contextes d'utilisation de la carte électronique : un premier contexte dans lequel le dispositif selon l'invention n'est pas nécessaire et un deuxième contexte dans lequel certains composants chauffent davantage et doivent bénéficier d'un chemin d'évacuation supplémentaire. Par ailleurs, le dispositif peut être installé pour différents formats de carte. Le processus de fabrication et de stockage des produits utilisant des cartes électroniques est ainsi simplifié.

Un autre avantage du dispositif selon l'invention est qu'il conserve l'indépendance entre les différents chemins d'évacuation des calories, et ce, sur l'intégralité des chemins, c'est-à-dire des points chauds jusqu'au mur froid. Ainsi, contrairement aux dispositifs de l'art antérieur dans lesquels les calories issues d'un point chaud sont transférées, au niveau du condensateur du caloduc, vers le drain thermique, réchauffant par conséquent les autres éléments de la carte électronique, le dispositif selon l'invention permet de transférer de manière indépendante la chaleur issue d'un composant vers un mur froid.

Le dispositif selon l'invention peut être utilisé dans le cadre d'un système de préchauffage d'un composant électronique, en adaptant le dispositif divulgué dans la demande de brevet français publiée sous le numéro FR2929070. En effet, en environnement très froid, une résistance chauffante peut être placée de sorte à élever la température de l'ensemble formé par le caloduc, la première pièce de conduction thermique et le composant, sans pour autant transmettre les calories à l'ensemble de la carte électronique. La résistance chauffante peut alors être placée sur le mur froid, et non plus sur la carte électronique, ce qui peut faciliter la conception du dispositif de préchauffage et son alimentation en énergie.

Par ailleurs, le dispositif selon l'invention bénéficie de bonnes performances de transferts thermiques grâce, d'une part à une surface d'échange avec le mur froid potentiellement grande, et d'autre part, à la présence d'une seule interface thermique au niveau du condensateur de chaque chemin de refroidissement (l'interface étant le passage entre la deuxième pièce de conduction thermique et le mur froid).

D'autres caractéristiques apparaîtront à la lecture de la description détaillée donnée à titre d'exemple et non limitative qui suit faite en regard de dessins annexés qui représentent :
- la figure 1, une carte électronique en coupe surmontée d'un drain thermique sans le dispositif selon l'invention ;
- la figure 2, une carte électronique pourvue du dispositif de refroidissement selon l'invention ;
- les figures 3a, 3b, 3c, 3d, plusieurs configurations possibles d'association entre des barreaux conducteurs thermiques et un caloduc du dispositif selon l'invention ;
- les figures 4a, 4b, 4c, 4d, plusieurs configurations possibles d'association entre des capots et barreaux conducteurs thermiques et un caloduc du dispositif selon l'invention.

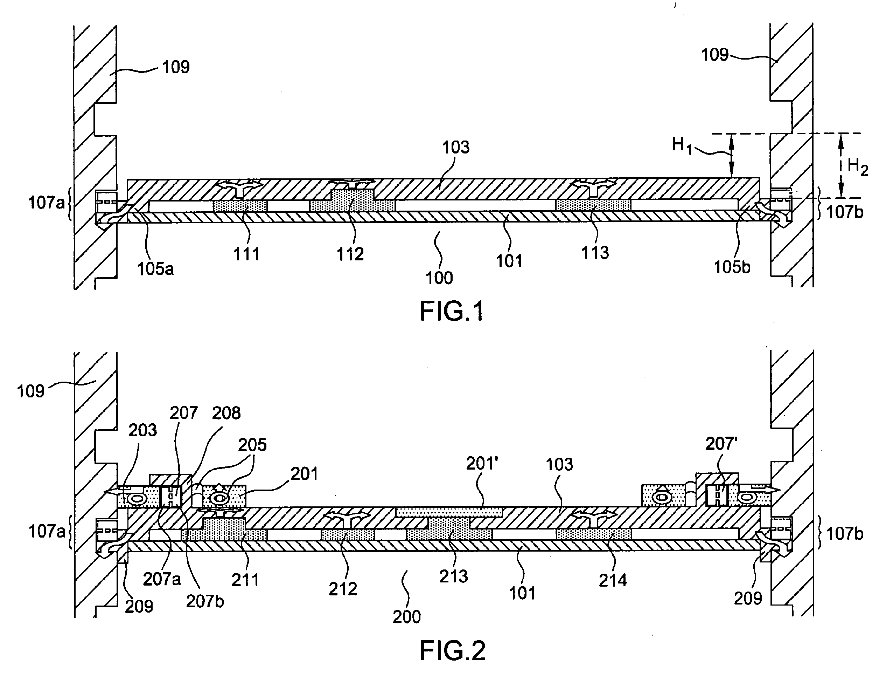

La figure 1, une carte électronique en coupe surmontée d'un drain thermique sans le dispositif selon l'invention. La carte électronique 100 comprend un circuit imprimé 101 et plusieurs composants 111, 112, 113 constituant des points chauds. Un drain thermique 103, qui dans l'exemple est spécialement adapté à la carte électronique 100, est monté au-dessus des composants 111, 112, 113 de manière à recueillir la chaleur dissipée par ceux-ci. Au niveau des bords 105a, 105b de la carte électronique, le drain thermique 103 entre en contact avec les glissières 107a, 107b du châssis 109 dans laquelle la carte 100 est insérée.

La figure 2, une carte électronique pourvue du dispositif de refroidissement selon l'invention. Le dispositif comprend une première pièce de conduction thermique 201, une deuxième pièce de conduction thermique 203, un caloduc 205 reliant les deux pièces de conduction thermique 201, 203, et des moyens de serrage 207.

La première pièce de conduction thermique 201 est accolée au flanc du drain thermique 103 qui est opposé au flanc en contact avec les composants 111, 112, 113 de la carte 100. La première pièce de conduction thermique 201 est maintenue en pression sur le drain thermique 103, à proximité d'un point chaud, par exemple, au-dessus d'un composant 211. La première pièce de conduction thermique 201 peut, par exemple, être un barreau métallique vissé sur le drain thermique 103 ou maintenu par un dispositif à effet ressort. Le serrage doit assurer une bonne conduction thermique entre la pièce de conduction 201 et le point chaud.

Selon un autre mode de réalisation également illustré sur la figure 2, la première pièce de conduction thermique 201' est placée directement en contact avec le point chaud — par exemple, sur un composant 213 —. Une pièce de conduction thermique 201, 203 peut être un bloc, par exemple un parallélépipède métallique plein 201, 203, que cette pièce soit un barreau 201 fixé sur le drain thermique 103 ou qu'elle prennent la forme d'un capot 201' obturant une ouverture formée dans le drain thermique 103, le capot 201' étant alors en contact direct avec le point chaud 213. Le choix entre l'emploi d'un barreau 201 ou d'un capot 201' est effectué notamment en fonction de la forme et de l'uniformité de la densité thermique de la zone à refroidir. Dans le cas d'un composant isolé et nécessitant un chemin spécifique de refroidissement, le capot 201', en contact direct avec le composant, sera privilégié.

La chaleur captée par la première pièce de conduction thermique 201 doit être ensuite évacuée ; le caloduc 205 est utilisé à cette fin. Le caloduc 205 peut être un tuyau de section rectangulaire incurvé pour relier les deux pièces de conduction thermique 201, 203. Par exemple, le caloduc 205 est incurvé dans un plan parallèle au drain thermique 103, le grand côté du tuyau étant positionné dans un plan orthogonal au plan d'incurvation. Ainsi, l'ensemble formé par le circuit imprimé 101, les composants 211, 212, 213, le drain thermique 103, et le dispositif selon l'invention ne dépasse pas la hauteur maximale entre deux emplacements, ou « slots », de cartes électroniques. A titre d'illustration, la hauteur H₁ entre la face supérieure du drain thermique 103 et la face inférieure de la glissière correspondant au slot situé au dessus de la carte électronique 100 peut être environ égale à 5mm, la hauteur H₂ entre la face inférieure du drain thermique 103 et la face inférieure de cette même glissière étant, par exemple, égale à 10mm. Le caloduc 205 permet de conduire les calories issues du point chaud 211 et transmises à la première pièce de conduction thermique 201 vers la deuxième pièce de conduction thermique 203. Selon un mode de réalisation du dispositif selon l'invention, la première pièce de conduction thermique 201, le caloduc 205, et la deuxième pièce de conduction thermique 203 ne sont qu'une seule et même pièce de matériau conformée. Un avantage de n'avoir qu'une seule pièce de matériau est d'éviter la présence d'interfaces thermiques entre le caioduc 205 et les pièces de conduction 201, 203, ces interfaces étant à l'origine de pertes caloriques. La deuxième pièce de conduction thermique 203 est placée au niveau d'un bord de la carte électronique 200, à proximité d'un mur froid, dans l'exemple le châssis 109, de manière à ce qu'en pressant la deuxième pièce de conduction thermique 203 contre le mur froid latéral 109, une surface d'échange thermique soit créée.

Le caloduc 205 bénéficie, selon le matériau dans lequel il est constitué, sa longueur et la forme qui lui a été donnée, d'une certaine souplesse qui confère une mobilité à la deuxième pièce de conduction thermique 203. Le caloduc 205 doit bénéficier d'une liberté de mouvement, et donc ne doit donc pas, par exemple, être totalement encastré dans le drain thermique 103. Dans l'exemple, la deuxième pièce de conduction thermique 203 peut se déplacer légèrement dans un plan parallèle au drain thermique 103 et selon un axe reliant sensiblement les deux pièces de conductions 201, 203. En outre, les moyens de serrages 207 sont disposés contre le flanc de la deuxième pièce de conduction 203 qui est opposé au mur froid 109. Les moyens de serrage 207 comprennent par exemple un système expansible de type « wedge lock », ce type de système comprenant deux parties mobiles l'une par rapport à l'autre, ces deux parties s'écartant par exemple en tournant une vis de serrage. Dans l'exemple, une première partie 207a du wedge lock est fixée à la deuxième pièce de conduction thermique 203 et une deuxième partie 207b du wedge lock est maintenue immobile par rapport au drain thermique 103, par exemple via une butée 208. La butée 208 peut être formée sur le drain thermique 103 pour retenir les moyens de serrage 207 et guider la deuxième pièce de conduction thermique 203 dans l'axe de déplacement souhaité.

La mobilité de la deuxième pièce de conduction 203 associée au système de serrage 207 permet au dispositif selon l'invention de prendre au moins deux positions différentes : une position ouverte dans laquelle les deux parties mobiles 207a, 207b des moyens de serrage 207 sont rapprochées, la deuxième pièce de conduction 203 étant alors écartée du mur froid 109, et une position verrouillée dans laquelle les deux parties 207a, 207b du wedge lock sont écartées, la deuxième pièce de conduction 203 étant alors pressée contre le mur froid 109 pour compléter le chemin d'évacuation thermique.

Ainsi, l'installation du dispositif selon l'invention sur une carte électronique peut être effectuée selon les étapes suivantes :
- installer sur le drain thermique 103 l'ensemble comprenant la première pièce conductrice 201, le caloduc 205, la deuxième pièce conductrice 203 et les moyens de serrage 207 en fixant la première pièce conductrice 201 au drain thermique 103 et en bloquant les moyens de serrage contre la butée 208 ;
- actionner les moyens de serrage 207 de manière à rapprocher les deux parties mobiles 207a, 207b ;
- insérer dans les glissières 107a, 107b du châssis 109, la carte électronique 200 pourvu du drain thermique 103 et du dispositif selon l'invention ;
- actionner les moyens de serrage 207 pour écarter les deux parties mobiles 207a, 207b afin de presser la deuxième pièce de conduction 203 contre le mur froid, c'est-à-dire le châssis 109.

Optionnellement, une protubérance 209 peut être formée dans le drain thermique 103 au niveau des extrémités proches des glissières 107a, 107b pour éviter que la carte 200 ne soit déplacée, par effet de contre-poussée, dans le sens opposé au sens de déplacement de la première partie mobile 207a du wedge lock ; la protubérance 209 permet ainsi de bloquer la carte électronique lors du verrouillage des moyens de serrage 207.

En outre, lorsque plusieurs dispositifs selon l'invention sont installés sur des bords opposés d'une même carte électronique 200, par exemple lorsqu'on souhaite évacuer la chaleur produite par plusieurs processeurs très calorifiques, il est préférable de verrouiller les moyens de serrage 207, 207' parallèlement et non pas séquentiellement, de manière à éviter tout endommagement du châssis 109 par un serrage déséquilibré.

Selon un autre mode de réalisation du dispositif selon l'invention, la première pièce de conduction thermique 201, 201' peut être intégrée au drain thermique 103. Par ailleurs, la première moitié 207a du wedge lock 207 peut être intégrée à la deuxième pièce de conduction thermique 203 afin de diminuer le nombre de pièces mobiles et faciliter le montage du dispositif.

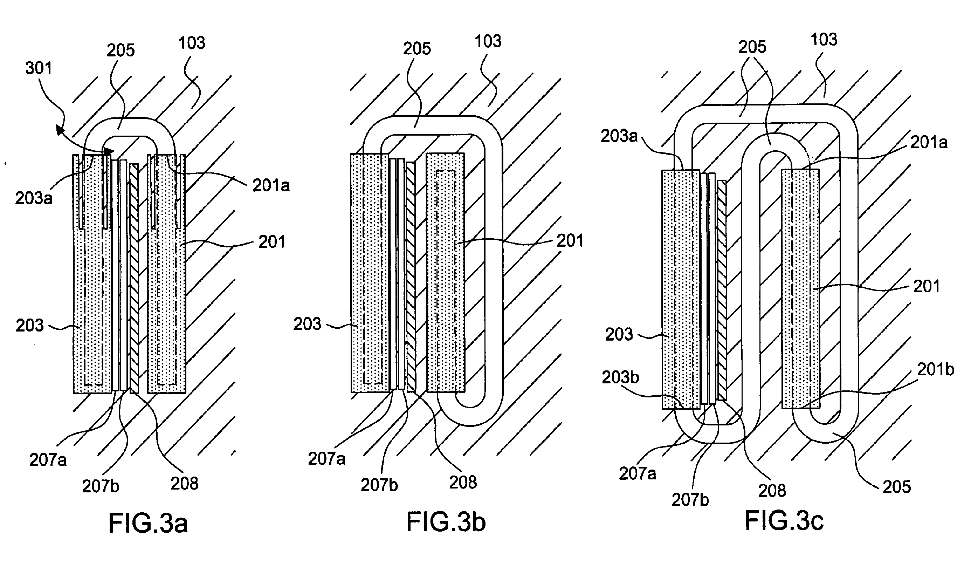

Les figures 3a, 3b, 3c, 3d présentent plusieurs configurations possibles d'association entre des barreaux conducteurs thermiques et un caloduc du dispositif selon l'invention. Dans les figures 3a, 3b, 3c, les première et deuxième pièces de conduction thermique 201, 203 sont des barreaux métalliques vus de dessus.

La figure 3a présente une première configuration dans laquelle les deux barreaux 203 sont reliés par un caloduc 205 de courte longueur conformé en U et parallèle au plan du drain thermique 103. Chaque extrémité du caloduc 205 est encastrée dans un barreau 201, 203, de manière à laisser, grâce à l'élasticité du caloduc 205, une certaine mobilité au barreau 203 accolé au wedge lock 207 et au caloduc 205, comme indiqué par la flèche 301. Par exemple, un faible espace vide pourra être réservé entre le caloduc 205 et chacun des barreaux 201, 203, au niveau des extrémités 201, 203a des barreaux, pour laisser un jeu au caloduc 205. Cette configuration présente notamment l'avantage de la simplicité.

La figure 3b présente une deuxième configuration dans laquelle le caloduc 205 est plus long que dans la première configuration. Cette configuration présente notamment l'avantage d'une plus grande souplesse du caloduc 205, grâce à sa longueur plus importante.

La figure 3c présente une troisième configuration dans laquelle le caloduc 205 traverse chacun des barreaux 201, 203. Dans l'exemple, le caloduc 205 relie la première extrémité 201a du premier barreau 201 à la deuxième extrémité 203b du deuxième barreau 203 et la première extrémité 203a du deuxième barreau 203 à la deuxième extrémité 201 b du premier barreau 201, lesdits barreaux 201, 203 étant traversés par le caloduc 205 de manière à optimiser les échanges thermiques. Cette configuration présente notamment l'avantage d'être plus indépendante de la gravité ou d'une autre force d'accélération que la première et la deuxième configuration, et ainsi de faciliter le déplacement des gouttes de fluide contenues dans le caloduc 205 vers un évaporateur.(point chaud). Cette configuration peut être utile lorsque la carte est soumise à des accélérations, par exemple si elle est embarquée dans un aéronef.

Les trois configurations illustrées en figures 3a, 3b et 3c peuvent aisément être adaptées à des échanges thermiques avec des capots plutôt qu'avec des barreaux.

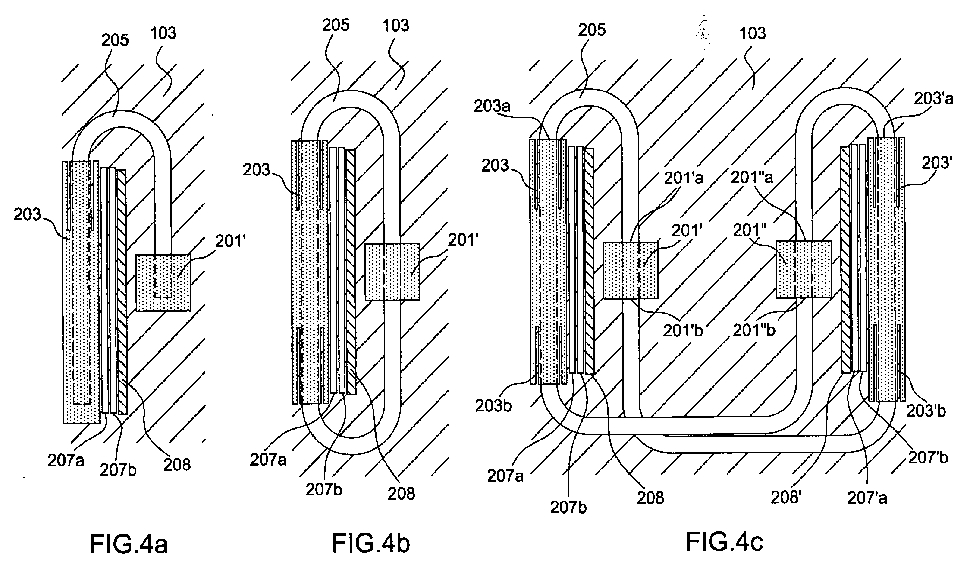

Les figures 4a, 4b, 4c, 4d présentent plusieurs configurations possibles d'association entre des capots et barreaux conducteurs thermiques et un caloduc du dispositif selon l'invention.

La figure 4a présente une quatrième configuration dans laquelle la première pièce de conduction est un capot 201' et la deuxième pièce de conduction est un barreau 203. Une extrémité du capot 201' et une extrémité du barreau 203 sont reliées par un caloduc 205. Comme la première configuration illustrée en figure 3a, cette configuration présente l'avantage de la simplicité.

La figure 4b présente une cinquième configuration dans laquelle la première pièce de conduction est un capot 201' et la deuxième pièce de conduction est un barreau 203. Un caloduc 205 traverse le barreau 203 et est accolé au capot 201', de manière à faire une boucle. Cette configuration permet un fonctionnement amélioré lorsque le dispositif est soumis à des accélérations.

La figure 4c présente une sixième configuration comprenant deux capots 201', 201 ", deux barreaux 203, 203'. Chaque barreau 203, 203' est placé contre un mur froid et chaque capot 201', 201" est placé sur un point chaud. La première extrémité 201'a du premier capot 201' est reliée à la première extrémité 203a du premier barreau 203, la deuxième extrémité 203b du premier barreau étant reliée à la deuxième extrémité 201 "b du deuxième capot 201 ", la première extrémité 201 "a étant reliée à la première extrémité 203a' du deuxième barreau 203', la deuxième extrémité 203b' du deuxième barreau 203' étant reliée à la deuxième extrémité 201 b' du premier capot 201'. Cette cinquième configuration permet de s'affranchir davantage des problèmes d'accélération ou de gravité, notamment lorsque la direction d'accélération ou de gravité est perpendiculaire aux glissières et est dans le plan du drain thermique 103 : si le refroidissement vers le mur froid contre lequel est placé le premier barreau 203 est contrarié par l'accélération, il se trouvera renforcé vers le mur froid contre lequel est placé le deuxième barreau 203', et inversement.

Le dispositif selon l'invention est un moyen auxiliaire d'évacuation de la chaleur pouvant être mis en place pour compléter le refroidissement opéré par le drain thermique 103. Il peut être installé pour des cartes électroniques de différentes dimensions. Par exemple, il peut être placé sur une carte électronique de type de largeur 6U = 233,5 mm ou sur une carte de type 3U = 100 mm.

Le dispositif selon l'invention est bien adapté aux nouvelles normes de dimensionnement des calculateurs modulaires, lesquelles tendent à augmenter la distance disponible entre deux slots (c'est-à-dire deux emplacements) de carte consécutifs. Notamment, le dispositif selon l'invention peut avantageusement être employé dans le cadre de la norme VPX (VITA-46), VITA étant l'acronyme pour VME INTERNATIONAL TRADE ASSOCIATION. VITA-46 est le nom d'une norme développée par VITA.

## Revendications

1. Dispositif auxiliaire pour évacuer par conduction la chaleur produite par un ou plusieurs composants d'une carte électronique (200) montée dans au moins une glissière (107a) formée dans un châssis (109) externe à ladite carte, ledit châssis formant un mur froid (109), le dispositif comprenant un drain thermique (103) recouvrant tout ou une partie de ladite carte (200), le dispositif comprenant au moins une première pièce de conduction thermique (201, 201') montée pour capter les calories produites par un ou plusieurs composants (211), un caloduc (205) reliant ladite première pièce (201, 201') avec une deuxième pièce de conduction thermique (203), **caractérisé en ce que** le caloduc (205) est disposé dans un plan parallèle et extérieur au drain thermique (103), le caloduc (205) étant pourvu d'une élasticité conférant à la deuxième pièce de conduction thermique (203) une mobilité dans un plan parallèle à ladite carte, le dispositif comprenant des moyens de serrage (207) aptes à presser la deuxième pièce mobile (203) contre une partie dudit mur froid (109) située à l'écart de ladite glissière (107a).

2. Dispositif selon la revendication 1, **caractérisé en ce que** les moyens de serrage (207) comprennent au moins deux parties mobiles (207a, 207b) l'une par rapport à l'autre, une première partie (207a) étant fixée à la deuxième pièce de conduction thermique (203), une deuxième partie (207b) étant maintenue immobile par rapport au drain thermique (103).

3. Dispositif selon la revendication 2, **caractérisé en ce qu'**il comprend, sur le drain thermique (103), des moyens de blocage (208) configurés pour maintenir les moyens de serrage (207) et la deuxième pièce de conduction thermique (203) en place lorsqu'un serrage de ladite deuxième pièce de conduction (203) est effectué contre le mur froid (109).

4. Dispositif selon l'une quelconque des revendications précédentes, **caractérisé en ce que** la première pièce de conduction thermique (201), la deuxième pièce de conduction thermique (203) et le caloduc (205) sont formés d'une seule et même pièce.

5. Dispositif selon l'une quelconque des revendications précédentes, **caractérisé en ce que** la première pièce de conduction thermique (201) est un bloc de matériau conducteur accolé à un flanc du drain thermique (103) à proximité d'un point chaud (213).

6. Dispositif selon l'une quelconque des revendications 1 à 4, **caractérisé en ce qu'**au moins une pièce de conduction thermique (201) est un capot (201') obturant une ouverture formée dans le drain thermique (103), ledit capot (201') étant placé en contact avec un point chaud (213) de la carte électronique (200).

7. Dispositif selon l'une quelconque des revendications précédentes, **caractérisé en ce que** le caloduc (205) est conformé en forme de U dans un plan parallèle au plan formé par le drain thermique (103), la première extrémité du U étant reliée à la première pièce de conduction (201), la deuxième extrémité du U étant reliée à la deuxième pièce de conduction (203).

8. Dispositif selon l'une quelconque des revendications 1 à 6, **caractérisé en ce que** le caloduc (205) forme une boucle fermée en contact avec la première pièce de conduction thermique (201') et la deuxième pièce de conduction thermique (203).

9. Dispositif selon l'une quelconque des revendications 1 à 6, **caractérisé en ce que** le caloduc (205) relie une première pièce de conduction (201') montée près d'un premier point chaud à une deuxième pièce de conduction (203) montée près d'un mur froid, le caloduc reliant la deuxième pièce de conduction (203) à une troisième pièce de conduction (201 ") montée près d'un deuxième point chaud, la troisième pièce de conduction (201 ") à une quatrième pièce de conduction (203') montée près d'un mur froid, ladite quatrième pièce (203') étant reliée par le caloduc (205) à la première pièce de conduction (201').

10. Carte électronique refroidie par conduction comprenant un dispositif selon l'une quelconque des revendications précédentes.

## Claims

1. Auxiliary device for dissipating by conduction the heat produced by one or more components of an electronic board (200) which is arranged in at least one sliding member (107a) formed in a frame (109) which is external with respect to the board, the frame forming a cold wall (109), the device comprising a heat sink (103) which covers all or a portion of the board (200), the device comprising at least a first thermal conduction component (201, 201') which is arranged in order to capture the heat energy produced by one or more components (211), a heat pipe (205) connecting the first component (201, 201') to a second thermal conduction component (203), **characterised in that** the heat pipe (205) is arranged in a plane which is parallel and external with respect to the heat sink (103), the heat pipe (205) being provided with a resilience which confers on the second thermal conduction component (203) a mobility in a plane parallel with the board, the device comprising clamping means (207) which are capable of pressing the second movable component (203) against a portion of the cold wall (109) located with spacing from the sliding member (107a).

2. Device according to claim 1, **characterised in that** the clamping means (207) comprise at least two portions (207a, 207b) which are movable relative to each other, a first portion (207a) being fixed to the second thermal conduction component (203), a second portion (207b) being retained so as to be fixed in relation to the heat sink (103).

3. Device according to claim 2, **characterised in that** it comprises, on the heat sink (103), locking means (208) which are configured to fix the clamping means (207) and the second thermal conduction component (203) in position when clamping of the second conduction component (203) is carried out against the cold wall (109).

4. Device according to any one of the preceding claims, **characterised in that** the first thermal conduction component (201), the second thermal conduction component (203) and the heat pipe (205) are formed integrally.

5. Device according to any one of the preceding claims, **characterised in that** the first thermal conduction component (201) is a conductive material block which is attached to a side of the heat sink (103) near a hot spot (213).

6. Device according to any one of claims 1 to 4, **characterised in that** at least one thermal conduction component (201) is a cap (201') which closes an opening formed in the heat sink (103), the cap (201') being positioned in contact with a hot spot (213) of the electronic board (200).

7. Device according to any one of the preceding claims, **characterised in that** the heat pipe (205) is in the form of a U in a plane parallel with the plane formed by the heat sink (103), the first end of the U being connect to the first conduction component (201), the second end of the U being connected to the second conduction component (203).

8. Device according to any one of claims 1 to 6, **characterised in that** the heat pipe (205) forms a closed loop in contact with the first thermal conduction component (201') and the second thermal conduction component (203).

9. Device according to any one of claims 1 to 6, **characterised in that** the heat pipe (205) connects a first conduction component (201') which is arranged near a first hot spot to a second conduction component (203) which is arranged near a cold wall, the heat pipe connecting the second conduction component (203) to a third conduction component (201 ") which is arranged near a second hot spot, the third conduction component (201") to a fourth conduction component (203') which is arranged near a cold wall, the fourth component (203') being connected by the heat pipe (205) to the first conduction component (201').

10. Electronic board cooled by conduction comprising a device according to any one of the preceding claims.

## Patentansprüche

1. Hilfsvorrichtung zum Ableiten durch Leitung der Wärme, die durch eine oder mehrere Komponenten einer elektronischen Karte (200) erzeugt wird, die in wenigstens einer Schiene (107a) montiert ist, die in einem Rahmen (109) außerhalb der Karte ausgebildet ist, wobei der Rahmen eine kalte Wand (109) bildet, wobei die Vorrichtung eine Wärmesenke (103) umfasst, die die Karte (200) ganz oder teilweise bedeckt, wobei die Vorrichtung wenigstens ein erstes Wärmeleitungsstück (201, 201') umfasst, das zum Erfassen der von einer oder mehreren Komponenten (211) erzeugten Kalorien montiert ist, wobei ein Wärmerohr (205) das erste Stück (201, 201') mit einem zweiten Wärmeleitungsstück (203) verbindet, **dadurch gekennzeichnet, dass** das Wärmerohr (205) in einer Ebene parallel zu und außerhalb der Wärmesenke (103) angeordnet ist, wobei das Wärmerohr (205) eine solche Elastizität aufweist, dass es dem zweiten Wärmeleitungsstück (203) eine Beweglichkeit in einer Ebene parallel zu der Karte verleiht, wobei die Vorrichtung Einspannmittel (207) umfasst, um das zweite bewegliche Stück (203) gegen einen Teil der kalten Wand (109) zu pressen, der von der Schiene (107a) beabstandet ist.

2. Vorrichtung nach Anspruch 1, **dadurch gekennzeichnet, dass** die Einspannmittel (207) wenigstens zwei bewegliche Teile (207a, 207b) in Bezug zueinander umfassen, wobei ein erster Teil (207a) am zweiten Wärmeleitungsstück (203) befestigt ist, wobei ein zweiter Teil (207b) unbeweglich in Bezug auf die Wärmesenke (103) gehalten wird.

3. Vorrichtung nach Anspruch 2, **dadurch gekennzeichnet, dass** sie an der Wärmesenke (103) Sperrmittel (208) umfasst, die zum Festhalten der Einspannmittel (207) und des zweiten Wärmeleitungsstücks (203) konfiguriert sind, wenn das zweite Wärmeleitungsstück (203) an der kalten Wand (109) eingespannt wird.

4. Vorrichtung nach einem der vorherigen Ansprüche, **dadurch gekennzeichnet, dass** das erste Wärmeleitungsstück (201), das zweite Wärmeleitungsstück (203) und das Wärmerohr (205) aus ein und dem selben Stück gebildet sind.

5. Vorrichtung nach einem der vorherigen Ansprüche, **dadurch gekennzeichnet, dass** das erste Wärmeleitungsstück (201) ein Block Leitermaterial ist, der an einer Flanke der Wärmesenke (103) in der Nähe einer heißen Stelle (213) angebracht ist.

6. Vorrichtung nach einem der Ansprüche 1 bis 4, **dadurch gekennzeichnet, dass** wenigstens ein Wärmeleitungsstück (201) eine Haube (201') ist, die eine Öffnung verschließt, die in der Wärmesenke (103) ausgebildet ist, wobei die Haube (201') in Kontakt mit einer heißen Stelle (213) der elektronischen Karte (200) platziert wird.

7. Vorrichtung nach einem der vorherigen Anspruch, **dadurch gekennzeichnet, dass** das Wärmerohr (205) in einer Ebene parallel zu der von der Wärmesenke (103) gebildeten Ebene U-förmig ausgestaltet ist, wobei das erste Ende des U mit dem ersten Leitungsstück (201) verbunden ist, wobei das zweite Ende des U mit dem zweiten Leitungsstück (203) verbunden ist.

8. Vorrichtung nach einem der Ansprüche 1 bis 6, **dadurch gekennzeichnet, dass** das Wärmerohr (205) eine geschlossene Schleife in Kontakt mit dem ersten Wärmeleitungsstück (201') und dem zweiten Wärmeleitungsstück (203) bildet.

9. Vorrichtung nach einem der Ansprüche 1 bis 6, **dadurch gekennzeichnet, dass** das Wärmerohr (205) ein erstes Leitungsstück (201'), das in der Nähe einer ersten heißen Stelle montiert ist, mit einem zweiten Leitungsstück (203) verbindet, das in der Nähe einer kalten Wand montiert ist, wobei das Wärmerohr das zweite Leitungsstück (203) mit einem dritten Leitungsstück (201") verbindet, das in der Nähe einer zweiten heißen Stelle montiert ist, das dritte Leitungsstück (201") mit einem vierten Leitungsstück (203'), das an einer kalten Wand montiert ist, wobei das vierte Stück (203') durch das Wärmerohr (205) mit dem ersten Leitungsstück (201') verbunden ist.

10. Elektronische Karte, die durch Leitung gekühlt wird, umfassend eine Vorrichtung nach einem der vorherigen Ansprüche.
